Europäisches Patentamt

European Patent Office

Office européen des brevets

(19)

(11) EP 0 535 263 B1

(12) **EUROPÄISCHE PATENTSCHRIFT**

(45) Veröffentlichungstag und Bekanntmachung des Hinweises auf die Patenterteilung:
**23.07.1997 Patentblatt 1997/30**

(51) Int Cl.6: **G01R 33/035**

(21) Anmeldenummer: **91116710.4**

(22) Anmeldetag: **30.09.1991**

(54) **SQUID-Messeinrichtung mit Mitteln zur Rauschreduktion**

SQUID measuring device with means for noise reduction

Dispositif de mesure SQUID aux moyens de réduction de bruit

(84) Benannte Vertragsstaaten:
**DE FR GB IT NL**

(43) Veröffentlichungstag der Anmeldung:
**07.04.1993 Patentblatt 1993/14**

(73) Patentinhaber: **SIEMENS AKTIENGESELLSCHAFT
80333 München (DE)**

(72) Erfinder: **Daalmans, Gabriel M.
W-8520 Erlangen (DE)**

(56) Entgegenhaltungen:
EP-A- 0 384 928       EP-A- 0 413 388
EP-A- 0 448 368       GB-A- 2 107 064

- IEEE TRANSACTIONS ON MAGNETICS. Bd. MAG23, Nr. 2, März 1987, NEW YORK US Seiten 1150 - 1153; V. FOGLIETTI ET AL.: 'A novel modulation technique for 1/f noise reduction in dc SQUIDs.'
- ELECTRONICS LETTERS. Bd. 15, Nr. 13, Juni 1979, STEVENAGE GB Seiten 372 - 373; P. GUTTMANN: 'D.C. SQUID with high energy resolution'

**Beschreibung**

Die Erfindung bezieht sich auf eine SQUID-Meßeinrichtung mit einem Gleichstrom-SQUID, die zu einer Reduktion des Rauschanteils in einem Ausgangssignal mit Mitteln zu einer Modulation eines durch das SQUID fließenden Bias-Stromes und mit Mitteln zu einer Modulation eines zusätzlich zu einem Meßfluß in das SQUID eingekoppelten Zusatzflusses versehen ist, wobei beide Modulationen mit Modulationssignalen der gleichen Frequenz und der gleichen Wellenform erfolgen. Eine SQUID-Meßeinrichtung mit einer entsprechenden Modulation ist der Veröffentlichung "IEEE Trans. Magn.", Vol. MAG-23, No. 2, März 1987, Seiten 1150 bis 1153 zu entnehmen.

Supraleitende Quanteninterferometer, sogenannte SQUIDs, können insbesondere im Hinblick auf eine Begrenzung des Rauschanteils der mit ihnen erzeugten Signale als Gleichstrom(DC)-SQUIDs ausgestaltet sein. Ein entsprechendes SQUID enthält als Hauptbestandteile eine supraleitende Schleife, in welche zwei Josephson-Elemente integriert sind. Über diese Schleife wird im allgemeinen ein sogenannter Bias-Strom geführt, mit dem die Strom-Spannungs-Charakteristik des SQUIDs auf ein bestimmtes Niveau zu legen ist. Ferner ist es allgemein üblich, DC-SQUIDs in einer den magnetischen Fluß konstant haltenden Schaltung ("flux-locked loop") zu betreiben, um so den Arbeitspunkt im SQUID zu stabilisieren. Hierbei handelt es sich um eine induktive Einkopplung eines von einem Rückkopplungssignal verursachten magnetischen Flusses in das SQUID. Das Rückkopplungssignal wird dabei am Ausgang eines dem SQUID nachgeordneten Verstärkerteils, im allgemeinen ein Lock-in-Verstärker, abgenommen. Dieser Rückkopplungssignalfluß wird dem SQUID zusätzlich zu einem Meßfluß zugeführt, der von einem zu detektierenden Eingangssignal hervorgerufen wird.

Um in einem rauscharmen Frequenzbereich der dem SQUID nachgeordneten Verstärker zu arbeiten, kann man außerdem das an dem SQUID hervorgerufene Spannungssignal auf eine vorbestimmte Trägerfrequenz bzw. Modulationsfrequenz legen. Dann ist es möglich, den Meßsignalanteil in ein anderes Frequenzband zu bringen, wo wenig Störsignale sind, und so eine elektronische Trennung von Stör- und Meßsignalen durchzuführen. Ein hierfür erforderliches Oszillatorteil mit einem Generator erzeugt ein entsprechendes Modulationssignal, welches induktiv als ein Zusatzfluß in das SQUID eingekoppelt wird. Vielfach wird das Modulationssignal in den Rückkopplungszweig eingespeist und so dem Rückkopplungssignal überlagert. Der zur Modulation vorgesehene Zusatzfluß enthält so auch das Rückkopplungssignal (vgl. z.B. "IEEE Trans. Electron Dev.", Vol. ED-27, No. 10, Okt. 1980, Seiten 1896 bis 1908).

Derartig betriebene DC-SQUIDs und somit auch die Einrichtungen, welche solche SQUIDs aufweisen, zeigen in ihren an dem nachgeordneten Verstärkerteil abzunehmenden Ausgangssignalen Rauschanteile, die auf ein sogenanntes 1/f-Rauschen zurückzuführen sind. Hierbei handelt es sich um ein niederfrequentes Rauschen, das bezüglich einer Frequenz f etwa eine spektrale 1/f-Energieverteilung zeigt. Für dieses Rauschen werden insbesondere Fluktuationen in den Josephson-Elementen des DC-SQUIDs verantwortlich gemacht (vgl. "Journ. of Low Temp. Phys.", Vol. 51, Nos. 1/2, 1983, Seiten 207 bis 224).

Zu einer Reduktion dieses 1/f-Rauschens ist aus der eingangs genannten Literaturstelle aus "IEEE Trans. Magn." eine besondere Betriebsart von DC-SQUIDs mit einer Flußmodulation zu entnehmen. Diese Betriebsart ist als SHAD (Second HArmonic Detection)-Prinzip bezeichnet. Hierzu ist eine Modulation des Bias-Stromes und des Zusatzflusses mit einer einheitlichen Modulationsfrequenz und mit einer einheitlichen Form der jeweiligen Modulationssignale vorgesehen.

Bei der bekannten SQUID-Meßeinrichtung ist eine Wellenform der jeweiligen Modulationssignale vorgesehen, die pro Schwingungsperiode drei diskrete Schwingungsamplitudenniveaus (bei 3/4 $\phi_o$, 1/4 $\phi_o$ und 1/2 $\phi_o$ des Zusatzflusses) mit verhältnismäßig großer Verweilzeit vorsieht. Am Ausgang eines dem SQUID nachgeordneten Lock-in-Verstärkers ist dann ein Ausgangs- bzw. Referenzsignal mit der zweifachen Modulationsfrequenz zu erhalten. Der elektronische Schaltungsaufwand der entsprechenden Oszillatoren zur Bias-Strom-Modulation und zur Modulation des Zusatzflusses ist dementsprechend hoch.

Aufgabe der vorliegenden Erfindung ist es, die Modulation der SQUID-Meßeinrichtung mit den eingangs genannten Merkmalen zu vereinfachen.

Diese Aufgabe wird erfindungsgemäß dadurch gelöst, daß periodische Modulationssignale vorgesehen sind, die eine stetig zwischen zwei in einer Periode nur kurzzeitig eingenommenen Extrema verlaufende Kurvenform aufweisen..

EP-A-0 448 368 offenbart ein analoges SQUID, wobei kein Hinweis auf Maßnahmen zu einer 1/f-Rauschunterdrückung erwähnt wird.

GB-A-2 107 064 offenbart ein RF-SQUID mit jeweils einem einzigen Josephson-Kontakt. Ein RF-SQUID kann jedoch nicht wie ein DC-SQUID moduliert werden.

Aus der EP-B-0 053 625 ist ebenfalls eine SQUID-Meßeinrichtung mit einer AC-Modulation lediglich des Bias-Stromes eines DC-SQUIDs bekannt. Bei dieser Einrichtung werden jedoch mehrere Modulatoren mit unterschiedlichen Frequenzen für erforderlich gehalten. Die hierfür vorzusehende Elektronik ist ausgesprochen aufwendig.

Demgegenüber sind die mit der erfindungsgemäßen Maßnahme verbundenen Vorteile gerade darin zu sehen, daß mit sehr einfachen elektronischen Oszillatoren (Generatoren) dem SHAD-Verfahren entsprechende Modulationen zu erreichen sind. Die Modulationssignale der erfindungsgemäßen Meßeinrichtung müssen dazu in einem Diagramm einen zeitabhängigen Kurvenverlauf zeigen, der in jeder Periode ein Maximalniveau und ein Minimalniveau im Gegensatz zu dem bekannten SHAD-Verfahren nur kurzzeitig, d.h. nur während eines unwesentlichen Anteils der Periodendauer, einnimmt und der diese Extrema über eine stetige (kontinuierlich verlaufende) Kurvenform verbindet. Entsprechende, besonders einfach zu realisierende Kurvenformen sind eine Sinusform oder eine Sägezahnform.

Vorteilhafte Ausgestaltungen der Meßeinrichtung nach der Erfindung gehen aus den Unteransprüchen hervor.

Zur weiteren Erläuterung der Erfindung wird nachfolgend auf die Zeichnung Bezug genommen, in deren Figur 1 ein Prinzipschaltbild zur Modulation des SQUIDs einer erfindungsgemäßen Meßeinrichtung veranschaulicht ist. In den Figuren 2 bis 4 ist jeweils schematisiert in einem Diagramm die Kennlinie des SQUIDs bzw. dessen Bias-Strom bzw. dessen Spannungssignal wiedergegeben. Die Figuren 5 bis 9 zeigen verschiedene Signale einer nach dem bekannten SHAD-Verfahren arbeitenden Meßeinrichtung. Diesen Signalen sind entsprechende, aus den Figuren 10 bis 14 zu entnehmende Signale einer erfindungsgemäßen Meßeinrichtung gegenübergestellt.

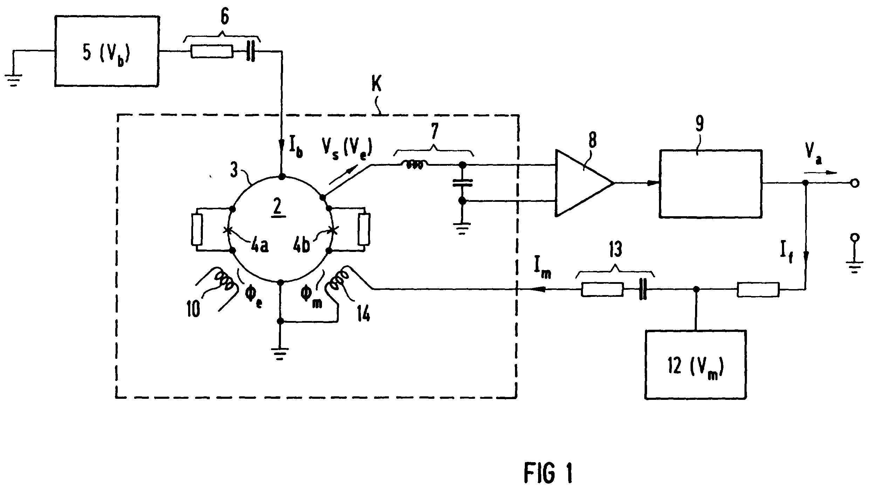

Bei der in Figur 1 skizzierten Schaltung eines DC-SQUIDs wird von der bekannten Flux-locked loop-Schaltung ausgegangen, wobei ein Modulationsverfahren entsprechend dem SHAD-Prinzip angenommen ist. Die Schaltung gibt nur einige für die Erfindung wesentliche Teile wieder. Weitere zum Betrieb einer entsprechenden Meßeinrichtung erforderliche Teile sind allgemein bekannt und deshalb nicht dargestellt. Ein Kryobereich K mit den auf einer kryogenen Betriebstemperatur zu haltenden Teilen ist durch eine gestrichelte Linie angedeutet.

Die Schaltung zeigt ein DC-SQUID 2, das in seiner SQUID-Schleife 3 zwei Josephson-Elemente 4a und 4b enthält. Über das SQUID ist ein Bias-Strom $I_b$ mit einer besonderen Kurvenform geführt, der sich aufgrund der Bias-Spannung $V_b$ eines AC-Oszillators 5 ergibt, welcher über ein RC-Glied 6 an das SQUID 2 angeschlossen ist. Ein an dem SQUID abzunehmendes Spannungssignal $V_s$ wird über ein Anpassungsnetzwerk 7 einem Verstärkerteil 8 zugeleitet. Diesem Verstärkerteil ist ein Lock-in-Verstärker 9 als phasensensitiver Detektor nachgeordnet. Dieser Verstärker erzeugt ein Ausgangssignal $V_a$, das in bekannter Weise einer in der Figur nicht dargestellten Elektronik zur Weiterverarbeitung zugeführt wird.

Ein in die SQUID-Schleife 3 über eine Koppelspule 10 induktiv einzukoppelnder, auf ein detektiertes Eingangssignal zurückzuführender Meßfluß $\phi_e$ soll von einem modulierten Zusatzfluß $\phi_m$ überlagert sein. Hierzu ist ein Modulationsoszillator 12 über ein RC-Glied 13 an eine der SQUID-Schleife 3 zuzuordnende Modulationsspule 14 angeschlossen. Dem Modulationsstrom $I_m$ durch diese Spule kann auch der Strom $I_f$ eines am Ausgang des Lock-in-Verstärkers 9 abgenommenen Rückkopplungssignals überlagert sein. Gegebenenfalls ist es aber auch möglich, eine davon getrennte Rückkopplung vorzusehen (vgl. "Journ. of Low Temp. Phys.", Vol. 25, No. 1/2, 1976, Seiten 99 bis 144, insbesondere Seite 112). Erfindungsgemäß sollen die von den Oszillatoren 5 und 12 zu erzeugenden Spannungssignale $V_b$ bzw. $V_m$ dieselbe Frequenz und dieselbe besondere Wellenform haben. Vorteilhaft ist es deshalb auch möglich, für beide Oszillatoren einen einzigen Generator vorzusehen. Die besondere Wellenform soll in einem Spannungs-Zeit-Diagramm einen zeitabhängigen, periodischen Kurvenverlauf zeigen, der zwischen zwei Extremwerten stetig verläuft. Außerdem darf die Kurve innerhalb einer Periode nur kurzfristig auf den Extremwerten verweilen. Diese Bedingungen lassen sich insbesondere mit einer Sinusform oder einer Sägezahnform des Kurvenverlaufs erfüllen. Auch eine Mischform aus einer Überlagerung der beiden vorgenannten Kurvenformen ist geeignet. Da eine Sinusform mit handelsüblichen Oszillatoren sehr leicht zu realisieren ist, wird für die weitere Beschreibung der erfindungsgemäßen Meßeinrichtung eine derartige Kurvenform angenommen.

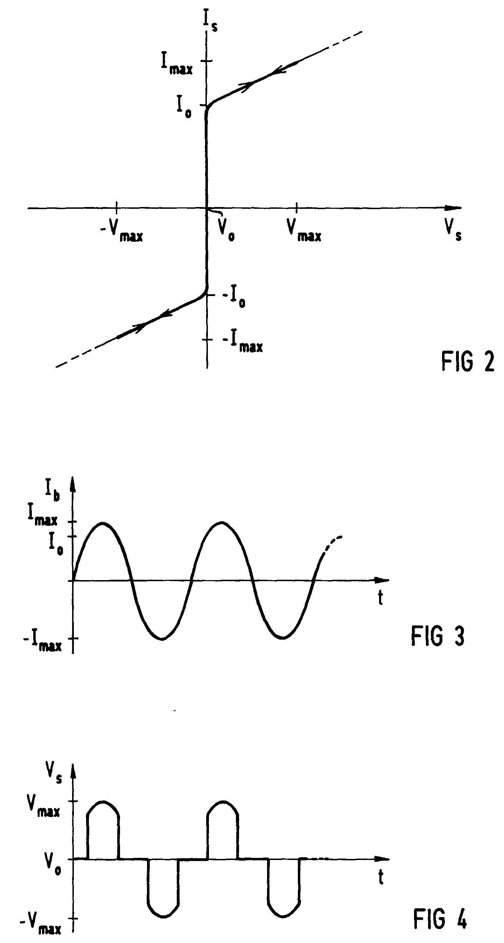

Figur 2 zeigt stark vereinfacht die Strom($I_s$)-Spannungs($V_s$)-Charakteristik eines DC-SQUIDs. Über dieses SQUID soll gemäß Figur 3 ein sinusförmiger Bias-Strom $I_b$ geleitet werden. Unter Zugrundelegung dieses Stromes wird dann der in Figur 2 verstärkt eingezeichnete Teil der Kurve in beiden Richtungen durchlaufen. Dabei sind $I_{max}$ und $-I_{max}$ die Scheitelwerte des Bias-Stromes, $I_o$ der kritische Strom des SQUIDs bei einem bestimmten Fluß-Bias sowie $V_{max}$ und $-V_{max}$ die Maximalwerte der SQUID-Spannung. In Figur 4 sind die entsprechenden, von dem Bias-Strom gemäß Figur 3 an dem SQUID hervorgerufenen Spannungsverhältnisse $V_s$ wiedergegeben. Man sieht aus dieser Figur deutlich, daß die Spannung $V_s$ drei zumindest weitgehend diskrete Spannungsniveaus bei $V_{max}$, $-V_{max}$ und $V_o$ (= Nullwert der Spannung) einnimmt.

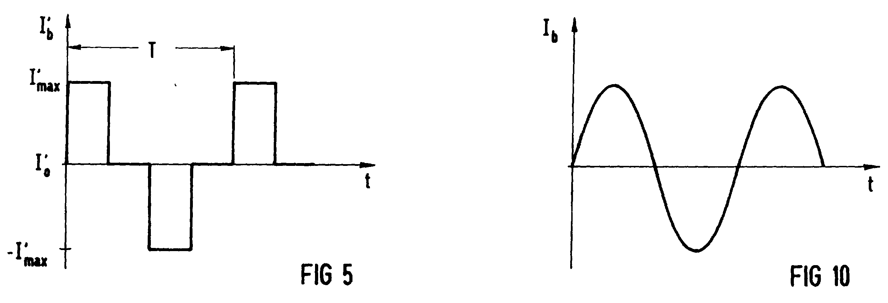

Die in den Diagrammen der Figuren 5 bis 9 dargestellten Kurven geben Verhältnisse wieder, wie sie bei einer bekannten Meßeinrichtung gemäß der eingangs genannten Veröffentlichung aus "IEEE Trans. Magn." mit einer Figur 1 entsprechenden Schaltung anzunehmen sind. In diesen Figuren sind zur Kennzeichnung als Stand der Technik die jeweiligen Ordinatengrößen zusätzlich mit einem "'" versehen.

Figur 5 zeigt die von der Zeit t abhängige Kurvenform des Bias-Stromes $I_b'$. Während der Dauer einer Schwingungsperiode T nimmt der Strom $I_b'$ drei diskrete Niveaus (Stufen) $I_{max}'$, $I_o'$ und $-I_{max}'$ ein.

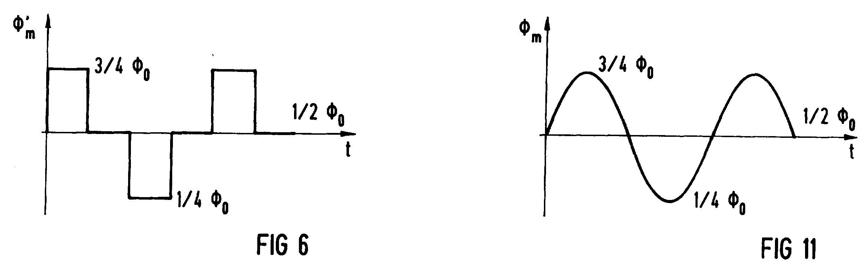

Gemäß Figur 6 soll auch der in das SQUID einzukoppelnde Zusatzfluß $\phi_m'$ entsprechend moduliert sein, d.h. dieselbe dreistufige Kurvenform haben. Die drei diskreten Niveaus liegen dabei bei $(3/4)\cdot\phi_o$, $(1/4)\cdot\phi_o$ und $(1/2)\cdot\phi_o$.

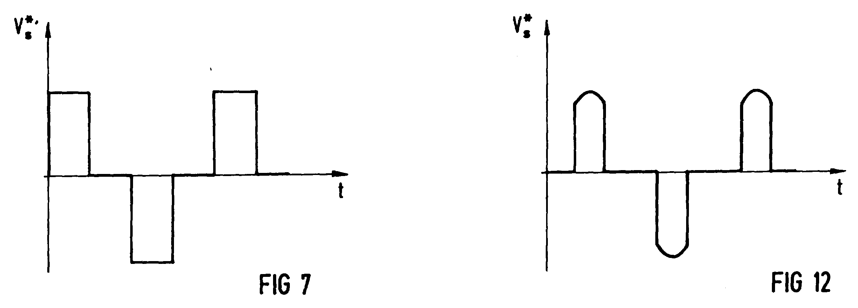

Figur 7 zeigt die aufgrund dieses Zusatzflusses an dem SQUID abzunehmende Spannung $V_s^{*'}$. Ein besonderer Meßfluß $\phi_e$ soll dabei nicht in das SQUID eingekoppelt sein.

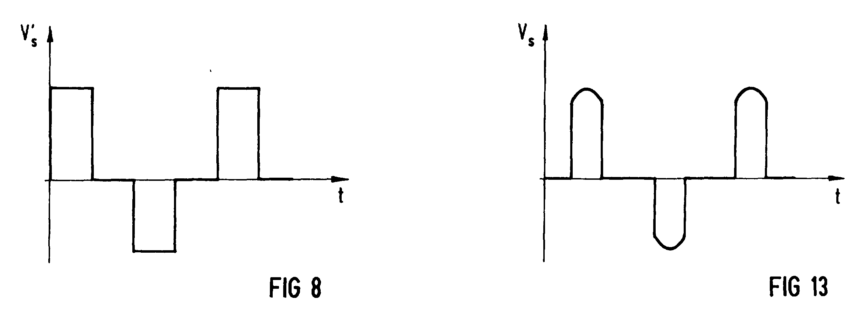

Wird jedoch zusätzlich zu den der Figur 7 zugrundegelegten Verhältnissen ein vorgegebener Wert eines Meßflusses $\phi_e$ angenommen, so ergibt sich der in Figur 8 gezeigte Verlauf der Spannungskurve $V_s'$.

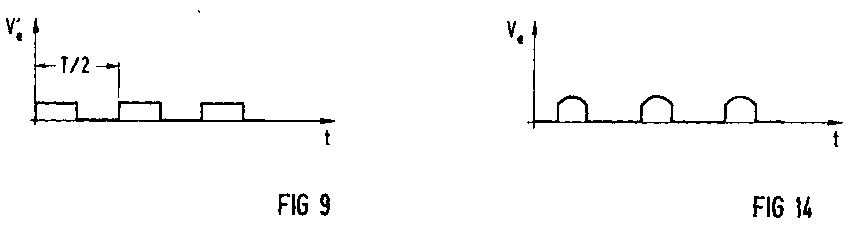

In Figur 9 ist der dann zu erhaltende Verlauf eines Signalanteils $V_e'$ an dem SQUID-Signal $V_s'$ wiedergegeben, welcher allein auf einen Meßfluß $\phi_e$ zurückzuführen ist. Dieser Signalanteil entspricht somit dem Meßsignal. Aus einem Vergleich mit der Schwingungsperiode T der Kurven 5 bis 8 ist ersichtlich, daß die Schwingungsperiode dieses Signalanteils $V_e'$ nur noch halb so lang ist (T/2), also dieser Signalanteil die doppelte Frequenz wie die Modulationssignale hat.

Den in den Diagrammen der Figuren 5 bis 9 dargestellten, sich für eine bekannte SQUID-Meßeinrichtung ergebenden Kurvenverläufen sind in den Figuren 10 bis 14 die entsprechenden Kurven für eine erfindungsgemäße Meßeinrichtung gegenübergestellt. Aus den anhand der Figuren 2 bis 4 erläuterten Gründen führen ein insbesondere sinusförmiger Bias-Strom $I_b$ (vgl. Figur 10) sowie eine sinusförmige Modulation des Zusatzflusses $\phi_m$ an dem SQUID (vgl. Figur 11) zu Spannungssignalen $V_s^*$ (Figur 12), die zumindest weitgehend denen nach dem bekannten SHAD-Verfahren (vgl. Figur 7) entsprechen. Die Modulationsfrequenz liegt dabei je nach Ausgestaltung des SQUIDs und der mit ihm verbundenen Bauteile der Meßeinrichtung zwischen einigen 100 Hz und dem MHz-Bereich, im allgemeinen zwischen 10 kHz und 500 kHz. Unter Berücksichtigung eines Meßflusses $\phi_e$ bei der SQUID-Spannung $V_s$ (Figur 13) werden dann Meßsignalanteile $V_e$ gewonnen (Figur 14), die ebenfalls die doppelte Modulationsfrequenz aufweisen. Das Ausgangssignal $V_a$ (vgl. Figur 1) ist dann auch mit dieser vergleichsweise höheren Frequenz moduliert. Die doppelte Frequenz ist zwar vorteilhaft besonders einfach zu realisieren (vgl. die Figuren 10 bis 14); gegebenenfalls erzeugt das SQUID wegen der Nicht-Linearität seiner Kennlinie auch Signale oder Signalanteile, deren Frequenz mehr als das 2-Fache der Modulationsfrequenz beträgt.

Gemäß dem Schaltbild nach Figur 1 wurde davon ausgegangen, daß bei der erfindungsgemäßen Meßeinrichtung ein von einer nichtdargestellten Schleifenanordnung (Magnetometer oder Gradiometer) detektiertes Eingangssignal als Meßfluß $\phi_e$ induktiv in die SQUID-Schleife 3 eingekoppelt wird. Das SQUID kann jedoch auch integrierter Bestandteil der Schleifenanordnung sein (vgl. z.B. "IEEE Trans. Magn.", Vol. MAG-19, No. 3, Mai 1983, Seiten 648 bis 651).

Ebensogut ist es ferner auch möglich, den modulierenden Zusatzfluß nicht direkt auf die SQUID-Schleife, sondern auf einen dieser Schleife vorangeordneten Flußtransformator einwirken zu lassen, mit dem ein detektierter Meßfluß dem SQUID zugeführt wird (vgl. z.B. "Journ. of Low Temp. Phys.", Vol. 25, No. 1/2, Seite 128 oder die US-A-4 320 341).

## Patentansprüche

1. SQUID-Meßeinrichtung mit einem Gleichstrom-SQUID, die zu einer Reduktion des 1/f-Rauschanteils in einem Ausgangssignal mit Mitteln zu einer Modulation eines durch das SQUID fließenden Bias-Stromes und mit Mitteln zu einer Modulation eines zusätzlich zu einem Meßfluß in das SQUID eingekoppelten Zusatzflusses versehen ist, wobei beide Modulationen mit Modulationssignalen der gleichen Frequenz und der gleichen Wellenform erfolgen, **dadurch gekennzeichnet**, daß periodische Modulationssignale ($I_b$, $I_m$) vorgesehen sind, die eine stetig zwischen zwei in einer Periode nur kurzzeitig eingenommenen Extrema verlaufende Kurvenform aufweisen.

2. Meßeinrichtung nach Anspruch 1, **dadurch gekennzeichnet**, daß die Modulationssignale von einem einzigen Generator zu erzeugen sind.

3. Meßeinrichtung nach Anspruch 1 oder 2, **dadurch gekennzeichnet**, daß der Meßfluß ($\phi_e$) induktiv über eine Koppelspule (10) in das SQUID (2) einzukoppeln ist.

4. Meßeinrichtung nach Anspruch 1 oder 2, **dadurch gekennzeichnet**, daß das SQUID integrierter Bestandteil einer feldsensitiven Schleifenanordnung ist.

5. Meßeinrichtung nach einem der Ansprüche 1 bis 4, **dadurch gekennzeichnet**, daß der Zusatzfluß ($\phi_m$) induktiv in das SQUID (2) einzukoppeln ist.

6. Meßeinrichtung nach einem der Ansprüche 1 bis 3, **dadurch gekennzeichnet**, daß der Zusatzfluß ($\phi_m$) induktiv in einen dem SQUID (2) vorangeordneten Flußtransformator einzukoppeln ist.

7. Meßeinrichtung nach einem der Ansprüche 1 bis 6, **dadurch gekennzeichnet**, daß an einem dem SQUID (2) nachgeordneten Verstärkerteil (8, 9) ein mit der doppelten Modulationsfrequenz moduliertes Ausgangssignal ($V_a$) zu erhalten ist.

8. Meßeinrichtung nach einem der Ansprüche 1 bis 7, **dadurch gekennzeichnet**, daß Modulationssignale ($I_b$, $I_m$) vorgesehen sind, die zumindest angenähert eine Sinus form oder eine Sägezahnform oder eine aus einer Überlagerung beider Formen gewonnene Signalform aufweisen.

## Claims

1. SQUID measurement device having a direct current SQUID, which measurement device, for a reduction of the l/f noise component in an output signal, is provided with means for modulating a bias current which flows through the SQUID and with means for modulating an additional flux coupled into the SQUID, the additional flux being provided in addition to a measurement flux, wherein both modulations are carried out with modulation signals of the same frequency and the same wave shape, **characterised in that** there are provided periodic modulation signals ($I_b$, $I_m$) which have a curve shape that runs continuously between two extremes occupied for only a short time within a period.

2. Measurement device according to claim 1, **characterised in that** the modulation signals are to be generated by a single generator.

3. Measurement device according to claim 1 or 2, **characterised in that** the measurement flux ($\phi_e$) is to be inductively coupled into the SQUID (2) by way of a coupling coil (10).

4. Measurement device according to claim 1 or 2, **characterised in that** the SQUID is an integral component of a field-sensitive loop arrangement.

5. Measurement device according to one of claims 1 to 4, **characterised in that** the additional flux ($\phi_m$) is to be inductively coupled into the SQUID (2).

6. Measurement device according to one of claims 1 to 3, **characterised in that** the additional flux ($\phi_m$) is to be inductively coupled into a flux transformer arranged in front of the SQUID (2).

7. Measurement device according to one of claims 1 to 6, **characterised in that** an output signal ($V_a$) modulated with twice the modulation frequency is to be obtained at an amplifier part (8, 9) arranged after the SQUID (2).

8. Measurement device according to one of claims 1 to 7, **characterised in that** there are provided modulation signals ($I_b$, $I_m$) which have at least approximately a sine shape or a saw-tooth shape, or a signal shape obtained by superimposing the two shapes.

**Revendications**

1. Dispositif de mesure SQUID avec un SQUID à courant continu, qui pour réduire la fraction de bruit l/f contenue dans un signal de sortie est doté de moyens permettant une modulation d'un courant bias parcourant le SQUID et de moyens permettant une modulation d'un flux additionnel envoyé en plus d'un flux de mesure dans le SQUID, les deux modulations étant effectuées au moyen de signaux de modulation ayant la même fréquence et la même forme d'onde, caractérisé en ce que des signaux de modulations ($I_b$, $I_m$) périodiques sont prévus qui présentent une courbe continue entre deux valeurs extrêmes occupées seulement momentanément dans une période.

2. Dispositif de mesure selon la revendication 1, caractérisé en ce que les signaux de modulation seront produits par un seul générateur.

3. Dispositif de mesure selon la revendication 1 ou 2, caractérisé en ce que le flux de mesure ($\Phi_e$) sera envoyé par induction dans le SQUID (2), par l'intermédiaire d'une bobine de couplage (10).

4. Dispositif de mesure selon la revendication 1 ou 2, caractérisé en ce que le SQUID fait partie intégrante d'une disposition à boucle sensible aux champs.

5. Dispositif de mesure selon l'une quelconque des revendications 1 à 4, caractérisé en ce que le flux additionnel ($\Phi_m$) sera envoyé par induction dans le SQUID (2).

6. Dispositif de mesure selon l'une quelconque des revendications 1 à 3, caractérisé en ce que le flux additionnel ($\Phi_m$) sera envoyé par induction dans un transformateur de flux placé en amont du SQUID (2).

7. Dispositif de mesure selon l'une quelconque des revendications 1 à 6, caractérisé en ce qu'au niveau d'un amplificateur (8, 9) placé en aval du SQUID (2) un signal de sortie ($V_a$) modulé par la double fréquence de modulation sera obtenu.

8. Dispositif de mesure selon l'une quelconque des revendications 1 à 7, caractérisé en ce que des signaux de modulation ($I_b$, $I_m$) sont prévus qui présentent au moins approximativement une forme sinusoïdale ou une forme en dents de scie ou une forme de signal obtenue par une superposition des deux formes.

FIG 1

EP 0 535 263 B1

FIG 2

FIG 3

FIG 4

FIG 10

FIG 5

FIG 11

FIG 6

FIG 12

FIG 7

$V'_s$

FIG 8

$V_s$

FIG 13

FIG 14

FIG 9